# EUROPEAN PATENT SPECIFICATION

(11) **EP 4 550 398 B1**
(45) Date of publication and mention of the grant of the patent: **18.11.2026**
(21) Application number: 24208607.2
(22) Date of filing: 24.10.2024
(51) Int. Cl.: H10W 42/00, H10W 70/692, H10W 70/05, H10W 70/60, H10W 70/63, H10W 70/68, H10W 70/685, H10W 74/10

(54) **SUBSTRATE HAVING SIDEWALL PROTECTION LAYER AND MANUFACTURING METHOD THEREOF**
SUBSTRAT MIT SEITENWANDSCHUTZSCHICHT UND HERSTELLUNGSVERFAHREN DAFÜR
SUBSTRAT AYANT UNE COUCHE DE PROTECTION DE PAROI LATÉRALE ET SON PROCÉDÉ DE FABRICATION

(30) Priority: 02.11.2023 US 202363595340 P
(43) Date of publication of application: 07.05.2025
(73) Proprietor: Absolics Inc., Covington, GA 30014 (US)
(72) Inventor: KIM, Hyejin, Covington, Georgia, 30014 (US)
(74) Representative: BCKIP Part mbB

(56) References cited:
- JP-A- 2014 022 483
- JP-A- 2018 113 283
- US-A1- 2022 102 230
- US-A1- 2023 087 838

## Description

This application claims the priority benefit of US provisional Application No. 63/595,340 filed on November 2, 2023.

### Technical Field of the Invention

The present invention relates to a substrate having a side protection layer that can be produced with reduced defects and improved yields, and a manufacturing method of the same. The present invention relates to a highly utilized substrate as a packaging substrate and a manufacturing method of the substrate.

### Background

When building an electronic component, implementing the circuitry on a semiconductor wafer is called the Front-End (FE), and assembling the wafer into a product-ready state is called the Back-End (BE). The latter includes the packaging process.

There are four core technologies in the semiconductor industry that have enabled the rapid development of electronic products in recent years: semiconductor technology, semiconductor packaging technology, manufacturing process technology, and software technology. Semiconductor technology is advancing in various forms, including sub-micron to nano-scale line widths, more than 10 million cells, high-speed operation, and high heat dissipation, but the technology to package them perfectly is relatively inadequate. Therefore, the electrical performance of semiconductors is often determined by packaging technology and electrical connections rather than the performance of the semiconductor technology itself.

Ceramic or resin may be applied as material for packaging substrates. Ceramic substrates, such as silicon substrates, have high resistivity or high dielectric constant, making it difficult to mount high-performance, high-frequency semiconductor elements. In the case of resin substrates, it is possible to mount relatively high-performance, high-frequency semiconductor devices. However, there are limitations in reducing the pitch of the wiring.

Recently, glass plates can be applied as substrates for high-end packaging. By forming through-holes in the glass substrate and applying conductive materials to the through-holes, the wiring length between the element and the motherboard can be shortened and have good electrical characteristics.
Document US 2023 / 0 087 838 A1 discloses a protective coating for an edge of a glass layer, in particular a glass core within a substrate of a package, where the protective coating serves to protect the edge of the glass core and fill in cracks at the edges of the glass.

### SUMMARY OF THE INVENTION

To accomplish the above objectives, the present invention provides a substrate in accordance with claim 1 and a manufacturing method of a substrate in accordance with claim 7.

A substrate according to the present invention is a substrate including a packaging substrate on which one or more electronic elements are disposed. The substrate includes a glass core comprising a first surface and second surface facing each other; a side surface connecting the first surface and second surface; an upper layer laminated on the first surface or a lower layer laminated under the second surface; and a side protection layer covering the side surface of the glass core with a protective material, wherein defect is formed in an inward direction of the glass core on the side surface of the glass core.

The protective material fills the space within the glass core caused by the defect.

The protective material may have a Young's modulus of 0.1 GPa to 17 GPa at 24 °C.

The packaging substrate includes the upper layer and the lower layer.

The side protection layer covers a side surface of the upper layer, a side surface of the glass core, and a side surface of the lower layer.

The protective material includes an elastic polymer resin.

The elastic polymer resin may have a curing temperature of 120 °C or higher.

The substrate may be a strip substrate in which a plurality of individual packaging substrates is arranged with dummy areas between them; a quad substrate in which dummy areas are arranged between a plurality of the strips; a panel substrate in which dummy areas are arranged between a plurality of the quads; or any of the above individual packaging substrates.

A side surface of the glass core protrudes from a side surface of the upper layer and a side surface of the lower layer.

The protective material may include an elastomeric polymer containing silane functional groups.

According to the present invention, a manufacturing method of a substrate comprises: operation A of preparing a substrate by preparing a glass core including a first surface and a second surface facing each other, forming an upper layer on the first surface and a lower layer under the second surface; and operation B of preparing a side protection layer on a side substrate of the substrate, the glass core having a defect formed on the side surface, the side protection layer filling the defect with a protective material and covering the side surface of the glass core.

The manufacturing method of the substrate may proceed to operation C at least once in the middle of the operation A or between the operation A and the operation B.

Operation C is an operation of confirming the occurrence of defects on the substrate in the operation A.

The manufacturing method of the substrate may further comprise operation D after the operation A.

The substrate of the operation A is a substrate in which a plurality of individual packaging substrates is arranged in a dummy region, and operation D is an operation of a singulation in which the individual packaging substrates are separated to obtain a packaging substrate.

### BRIEF DESCRIPTION OF THE DRAWINGS

FIG. 1 is a conceptual diagram illustrating a cross-sectional structure of a packaging substrate, according to an embodiment.
FIG. 2 is a conceptual diagram illustrating a cross-sectional structure of a packaging substrate, according to another embodiment.
FIGS. 3A and 3B are conceptual diagrams illustrating a cross-sectional view of a portion of a packaging substrate, according to an embodiment, respectively.
FIGS. 4A to 4E are flowcharts illustrating a process for preparing a core distribution layer during the manufacturing method of a packaging substrate, in a cross-sectional view, according to an embodiment.
FIGS. 5A to 5E are flowcharts illustrating a process for creating an insulating layer during manufacturing of a packaging substrate, in a cross-sectional view, according to an embodiment.
FIG. 6 is a perspective view of a substrate having a side protection layer, according to an embodiment.
FIG. 7A is an exemplary conceptual view of a substrate cross-section before the side protection layer is formed, as seen in A-A' of FIG. 6, and FIG. 7B is an exemplary conceptual view of a substrate cross-section after the side protection layer is formed, as seen in A-A' of FIG. 6, wherein the embodiment of FIGS. 7A and 7B is not covered by the claimed invention.
FIG. 8A is another exemplary conceptual view of a substrate cross-section before the side protection layer is formed, as shown in A-A' of FIG. 6, and FIG. 8B is another exemplary conceptual view of a substrate cross-section after the side protection layer is formed, as shown in A-A' of FIG. 6.
FIG. 9A is another exemplary conceptual view of a substrate cross-section before forming the side protection layer as shown in A-A' of FIG. 6, and FIG. 9B is another exemplary conceptual view of a substrate cross-section after forming the side protection layer as shown in A-A' of FIG. 6.

### DESCRIPTION OF THE EMBODIMENTS

In order to provide a comprehensive understanding of the methods, apparatus, and/or systems described herein, the following detailed description is provided. The sequence of operations described herein is by way of example only and is not intended to be limiting to the operations described herein. With the exception of steps that are not necessarily performed in a particular order, the order of operations may be altered based on an understanding of what is disclosed herein. In addition, descriptions of features already known in the art may be omitted for clarity and brevity after understanding the disclosure of this application. However, the omission of such features and their descriptions is not intended to be recognized as general knowledge.

The features described herein may be implemented in different forms and are not to be construed as being limited to the examples described herein. Rather, the embodiments described herein are provided to illustrate some of the many possible ways of implementing the methods, devices, and/or systems described herein that will become apparent after understanding the disclosures of this application.

The terms "first," "second," "third," and the like may be used herein to describe various members, components, regions, layers, or sections, but are not intended to limit the members, components, regions, layers, or sections to these words. Instead, these terms are used for the purpose of distinguishing one member, component, region, layer, or section from another member, component, region, layer, or section. Thus, a first member, component, region, layer, or section referred to in the embodiments described herein may also be referred to as a second member, component, region, layer, or section without departing from the teachings of the embodiments.

Throughout the specification, when an element, such as a layer, region, or substrate, is described as being "on," "connected to," or "coupled to" another element, it may be described as being directly "on," "connected to," or "coupled to" the other element, or it may have one or more other elements interposed between them. In contrast, when an element is described as "directly on", "directly connected to", or "directly coupled to" another element, no other element can intervene between them. Similarly, for example, expressions such as "between" and "directly between," and "abutting" and "directly abutting" can also be interpreted as described above.

The terms used in this specification are intended to describe specific examples and are not intended to limit disclosure. The singular form used herein is intended to include the plural form unless the context clearly indicates otherwise. As used herein, the term "and/or" includes any one or a combination of two or more of the relevant list items. The terms "comprising," "consisting of," and "having" as used herein specify the presence of the specified features, numbers, actions, elements, components, and/or combinations thereof, but do not exclude the presence or addition of one or more other features, numbers, actions, elements, components, and/or combinations thereof. The use of the term "may" in this specification with respect to an example or embodiment (e.g., with respect to what an example or embodiment may include or implement) implies that there is at least one example or embodiment that includes or implements such features, but not all examples are limited thereto.

For the purposes of this application, "B being located on A" means that B is placed on top of A, either in direct contact with A or with another layer or structure interposed therebetween, and should not be construed to mean that B is in direct contact with A.

Unless otherwise defined, all terms used herein shall have the same meaning as commonly understood by one of ordinary skill in the art to which the present invention belongs. Such terms, as defined in commonly used dictionaries, shall be construed to have a meaning consistent with their meaning in the context of the prior art and the present invention and shall not be construed in an idealized or overly formal sense unless expressly defined herein.

In one or more of the examples, a description of "A and/or B" means "A, B, or A and B".

In one or more of the examples, terms such as "first," "second," "A," or "B" are used to distinguish identical terms from each other.

In one or more of the examples, singular forms are contextually interpreted to include the plural as well as the singular, unless otherwise noted.

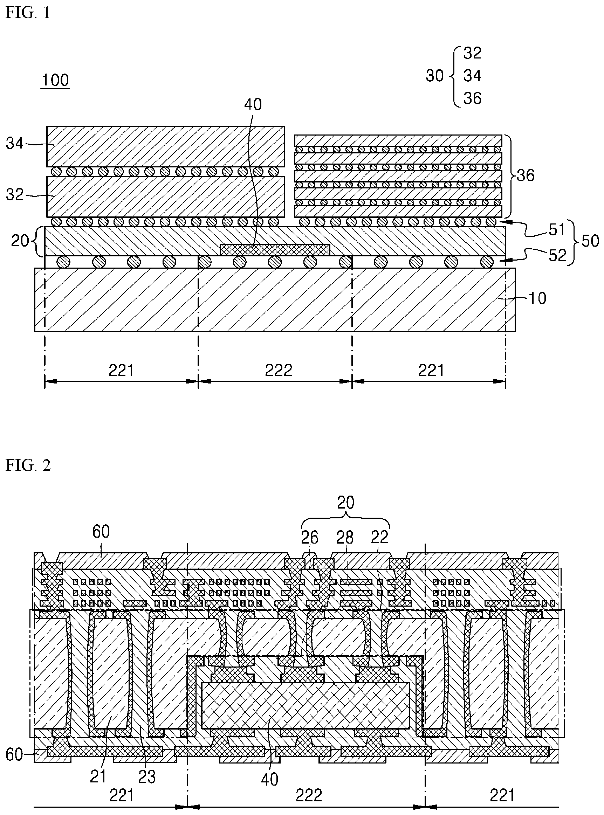

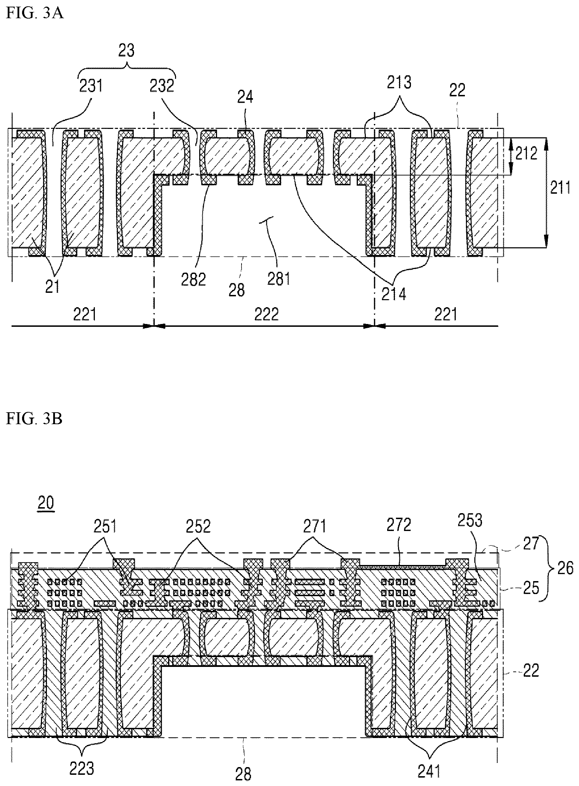

FIG. 1 is a conceptual diagram illustrating a cross-sectional structure of a packaging substrate according to an embodiment, FIG. 2 is a conceptual diagram illustrating a cross-sectional structure of a packaging substrate according to another embodiment, and FIGS. 3A and 3B are conceptual diagrams illustrating a cross-sectional view of a portion of a packaging substrate, according to an embodiment, respectively.

To accomplish the above objectives, a semiconductor device 100 according to an embodiment comprises a semiconductor element portion 30 on which one or more semiconductor elements 32, 34, 36 are located; a packaging substrate 20 electrically connected to the semiconductor elements; and a motherboard 10 electrically connected to the packaging substrate 20 and transmitting external electrical signals to and connecting the semiconductor elements 32, 34, 36 with each other.

The packaging substrate 20, according to one embodiment, comprises a core layer 22, an upper layer 26 located on a first surface of the core layer 22, and a cavity portion 28 in which a cavity element 40 may be located.

The semiconductor element portion 30 refers to an element mounted on a semiconductor device and is mounted on the packaging substrate 20 by means of a connection electrode or the like. Specifically, the semiconductor element portion 30 can be applied to, for example, a computing element (first element: 32, second element: 34) such as a CPU or GPU, a memory element (third element, 36) such as a memory chip, etc.

The motherboard 10 may be a motherboard such as a printed circuit board, a printed wiring board, or the like.

The packaging substrate 20 further comprises a lower layer (not shown) positioned below the core layer.

A core layer 22 comprises a glass substrate 21, a plurality of core vias 23 and a core distribution layer 24. The glass substrate 21 comprises a first zone 221 having a first thickness 211 and a second zone 222 having a second thickness 212 that is adjacent to the first zone 221 and is either less than the first thickness (half cavity) or has a thickness of 0 mm (full cavity). The plurality of core vias 23 penetrates the glass substrate 21 in the thickness direction. And the core distribution layer 24 is located on a surface of the glass substrate 21 or of the core vias 23, electrically connects a first surface 213 of the glass substrate 21, and a second surface 214 facing the first surface via the core vias 23.

The second zone 222 of the core layer 22 may serve as a cavity structure.

Within the same zone, the glass substrate 21 has a first surface 213 and a second surface 214 that face each other, and these two sides are substantially parallel to each other and have a constant thickness throughout the glass substrate 21.

The inner space 281 formed by the difference in thickness of the first zone 221 and the second zone 222 serves to house some or all of the cavity elements 40.

The glass substrate 21 may comprise core vias 23 through the first surface 213 and the second surface 214. The core vias 23 may be formed in both the first zone 221 and the second zone 222 and may be formed in any desired pitch and pattern.

As a packaging substrate for semiconductor devices, silicon substrates and organic substrates have traditionally been applied in a laminated form. In the case of silicon substrates, due to the nature of semiconductors, parasitic elements may occur when applied to high-speed circuits, and power losses are relatively high. In addition, organic substrates require large area to form more complex distribution patterns, which is inconsistent with the trend of miniaturization of electronic devices. In order to form a complex distribution pattern within a certain size, pattern refinement is practically necessary, but there were practical limitations in pattern refinement due to the characteristics of materials such as polymers applied to organic plates.

In an embodiment, a glass substrate 21 is applied as a support for the core layer 22 as a way to address these issues. In addition, a core via 23 formed through the glass substrate 21 is applied along with the glass substrate 21 to provide the packaging substrate 20 with shorter electrical flow lengths, more miniaturization, faster response, and lower loss characteristics.

The glass substrate 21 is preferably a glass substrate applied to semiconductors, and for example, a borosilicate glass substrate, an alkali-free glass substrate, and the like may be applied, but is not limited thereto.

The core via 23 penetrates the glass substrate 21. The core via 23 may be formed in such a way as to remove a predetermined area of the glass substrate 21, in particular by etching the plate glass by physical and/or chemical means.

Specifically, the formation of the core via 23 may be accomplished by forming defects (inclusions) on the surface of the glass substrate by means of a laser or the like, followed by chemical etching, laser etching, and the like, but is not limited to.

Based on a unit area (1 cm x 1 cm) of the glass substrate 21, the number of the core via 23 may be from 100 to 3,000, from 100 to 2,500, or from 225 to 1,024. If such a pitch condition is satisfied, the formation of an electrically conductive layer or the like and the performance of the packaging substrate may be improved.

The core distribution layer 24 comprises a core distribution pattern 241, which is an electrically conductive layer electrically connecting the first and second surfaces of the glass substrate via through vias, and a core insulating layer 223 surrounding the core distribution pattern. The core layer 22 has an electrically conductive layer formed therein through the core vias, which acts as an electrical pathway across the glass substrate 21 and may connect the top and bottom of the glass substrate over a relatively short distance, resulting in faster electrical signal transfer and low loss. The electrically conductive layer may be, for example, but not limited to, a copper plating layer.

The cavity portion 28 is substantially circular, triangular, square, hexagonal, octagonal, cross-shaped, or otherwise non-limiting in shape.

The cavity element 40 may be generally cylindrical, cuboidal, or polygonal in shape.

The cavity portion 28 may comprise a cavity distribution pattern, which is an electrically conductive layer electrically connecting the cavity element 40 and the core distribution layer 24, and an insulating layer surrounding the cavity distribution pattern.

In other embodiments, the cavity portion may be implemented in a form that penetrates the first surface 213 and the second surface 214 of the glass substrate 21. In this case, the cavity portion may be formed according to a process similar to the formation process of the core vias 23 and may differ from the core vias 23 in the area and shape that it penetrates the glass substrate 21.

In such an embodiment, an insulating layer may be prepared in the cavity portion after it is arranged in the cavity element 40, i.e., an insulating layer may be prepared in the cavity portion through the process of preparing the core insulating layer 223 described above.

The core distribution pattern 241 may be patterned to be electrically coupled to the cavity element 40.

The cavity element 40 may comprise an active element, such as a transistor, or a passive element, such as a power transfer element, such as a multilayer ceramic capacitor (MLCC).

If an element such as a transistor, which plays a role in converting electrical signals between the motherboard and the semiconductor element portion to an appropriate level, is applied to the cavity element 40, the packaging substrate 20 may be formed in a form in which a transistor or the like is applied in the way of the packaging substrate 20, thereby providing a semiconductor device 100 having a more efficient and faster speed.

In addition, power transfer elements, such as multilayer ceramic capacitors (MLCCs), play an important role in the performance of semiconductor devices. It is common for at least 200 or more power transfer elements, which are passive elements, to be applied to a semiconductor device, and their performance in transferring power is also affected by the characteristics of the electrically conductive layer surrounding the element. In one embodiment, non-circular shaped core via can be applied where a low resistance electrically conductive layer is required, such as in power transfer devices.

On the other hand, a passive element such as a capacitor may be inserted individually and applied to the cavity element 40. Or a group of elements comprising a plurality of passive elements in a form embedded between an insulator layer (cavity element insulation layer) may be formed so that the electrodes are exposed and then inserted into the cavity. The latter option is more workable for packaging substrate fabrication and more favorable for ensuring that the insulating layer is sufficiently and reliably located in the space between complex elements.

The glass substrate 21 plays an intermediate role, an intermediary role, connecting the semiconductor element portion 30 and the motherboard 10 on the upper and lower sides, respectively, and the core via 23 acts as a passageway for transmitting electrical signals therebetween, thereby facilitating smooth signal transmission. For the purpose of distinguishing from the core via of the second zone 222 described later, the core via disposed in the first zone 221 will be referred to as the first zone core via 231.

Above the first surface 213 is the upper layer 26.

The upper layer 26 may comprise an upper distribution layer 25 and a top contact layer 27 positioned on the upper distribution layer 25, and the uppermost surface of the upper layer 26 may be protected by a cover layer 60 having an opening formed through which the contact electrodes of the semiconductor element may directly contact.

The upper distribution layer 25 may comprise an upper insulating layer 253 positioned on the first surface; and an upper distribution pattern 251 embedded in the upper insulating layer 253 as an electrically conductive layer having a predetermined pattern and electrically connecting at least a portion thereof with the core distribution layer 24. The upper distribution layers 25 disposed above and below each other may be connected to each other via blind vias 252.

The upper insulating layer 253 may be applied as an insulator layer to a semiconductor device or packaging substrate, and may be, for example, an epoxy-based resin containing fillers, but is not limited to.

The insulator layer may be formed by forming a coating layer and curing it, or it may be formed by laminating an uncured or semi-cured insulator film to the core layer 22 and curing it. In this case, by applying a pressure-sensitive lamination method or the like, the insulating material can be embedded into the space inside the core vias 23 and the process can proceed efficiently.

In some embodiments, the plurality of insulating layers may be stacked and substantially indistinguishable between the insulating layers, and the plurality of insulating layers are collectively referred to as the upper insulating layer. Additionally, the core insulation layer 223 and the upper insulation layer 253 may be applied the same insulating material, in which case the boundary between them may be substantially indistinguishable. Alternatively, in other implementations, the boundaries of the insulation layers may be created by setting different pressures and temperatures to cure the multiple insulator layers.

The upper distribution pattern 251 refers to an electrically conductive layer located within the upper insulating layer 253 in a preset shape, which may be formed, for example, in a build-up layer method. Specifically, the upper distribution pattern 251 may be formed by forming an insulator layer, removing an unnecessary portion of the insulator layer, forming an electrically conductive layer by copper plating or the like, optionally removing an unnecessary portion of the electrically conductive layer, forming an insulator layer on top of the electrically conductive layer, removing an unnecessary portion of the insulator layer, forming an electrically conductive layer by plating or the like, and so on, so that the electrically conductive layer is formed in a vertical or horizontal direction in the desired pattern.

Since the upper distribution pattern 251 is located between the core layer 22 and the semiconductor element portion 30, it is formed to comprise a fine pattern in at least a portion thereof so that the transmission of electrical signals to the semiconductor element portion 30 can proceed smoothly and the intended complex pattern can be sufficiently accommodated. In this case, the fine-patterns may have a width and spacing of less than 4 µm, 3.5 µm or less, 3 µm or less, 2.5 µm or less, or 1 to 2.3 µm (hereinafter, the description of the fine-patterns will be the same).

The top contact layer 27 comprises a top surface connection pattern 272 electrically connected, at least partially, with the upper distribution pattern 251 and located on the upper insulating layer 253, and a top surface connection electrode 271 electrically connecting the top surface connection pattern 272 with the semiconductor element portion 30.

The top surface connection pattern 272 may be located on a first surface of the upper insulating layer 253, or at least a portion thereof may be exposed and embedded in the upper insulating layer. For example, if the top surface connection pattern is located on one side of the upper insulating layer, the upper insulating layer may be formed by plating or the like, and if the top surface connection pattern is embedded with a part of it exposed on the upper insulating layer, it may be that a part of the insulating layer or the electrically conductive layer is removed by surface polishing, surface etching, or the like after forming a copper plating layer or the like.

The top surface connection pattern 272 may comprise at least a portion of a fine pattern, such as the upper distribution pattern 251 described above. The top surface connection pattern 272 comprising such fine patterns enables a larger number of elements to be electrically connected in a smaller area, allowing for smoother electrical signal connections between elements or to the outside world, and more integrated packaging.

The top surface contact electrode 271 may be directly connected to the semiconductor element portion 30 by terminals or the like or may be connected via an organic connection 51 such as a solder ball.

The cavity portion 28 may comprise a cavity distribution layer 282 located above and/or below the second zone 222 and electrically connected to the core distribution pattern 241, and an inner space 281 in which the cavity elements 40 are located. The cavity distribution layer 282 may be formed through the second zone core via 232.

Specifically, the second zone 222 has a thinner thickness of the glass substrate 21 compared to the first zone 221, and the cavity element 40 may be located in the inner space 281 formed due to the difference in thickness. Furthermore, the core vias 23 and the core distribution layer 24 formed on the glass substrate 21 serve as an electrical connection structure connecting the cavity element 40 and the external element.

Furthermore, as described above, a cavity portion in the form of penetrating the first zone 221, i.e., the first surface 213 and the second surface 214 of the glass substrate 1, rather than the second zone 222, may be created, and the cavity element 40 may be arranged in the cavity portion.

The packaging substrate 20 is also connected to a motherboard 10. The motherboard 10 may be electrically connected to the core distribution pattern 241 located on at least a portion of the second surface 214 of the core layer 22 by terminals of the motherboard 10, either directly or via a board connection portion 52 such as a solder ball. In addition, the core distribution pattern 241 in contact with the motherboard 10 may be connected to the motherboard 10 via a lower layer (not shown) located at the bottom of the core layer 22. The element connection portion 51 and the board connection portion 52 are collectively referred to as the connection portion 50.

In one example, no substantially additional substrate other than the glass substrate 21 may be applied to the packaging substrate 20 positioned between the semiconductor element portion 30 and the motherboard 10.

Traditionally, the interposer and organic substrate are laminated together between the element and the motherboard. This multi-step application is understood to be necessary for at least two reasons: one is that there are scale issues with directly bonding the fine pattern of the element to the motherboard, and the other is that wiring damage may occur during the bonding process or during the driving of the semiconductor device due to differences in thermal expansion coefficients. The embodiment solves these problems by applying a glass substrate having a coefficient of thermal expansion similar to that of a semiconductor device and forming a fine pattern on the first surface of the glass substrate and an upper layer thereof having a scale fine enough for mounting the element.

In the following, a manufacturing method of a packaging substrate according to an embodiment of the present invention will be described.

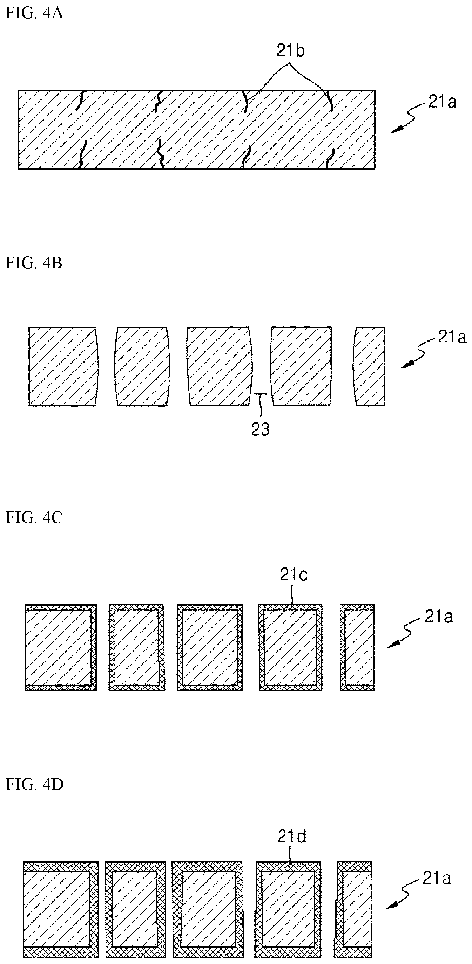

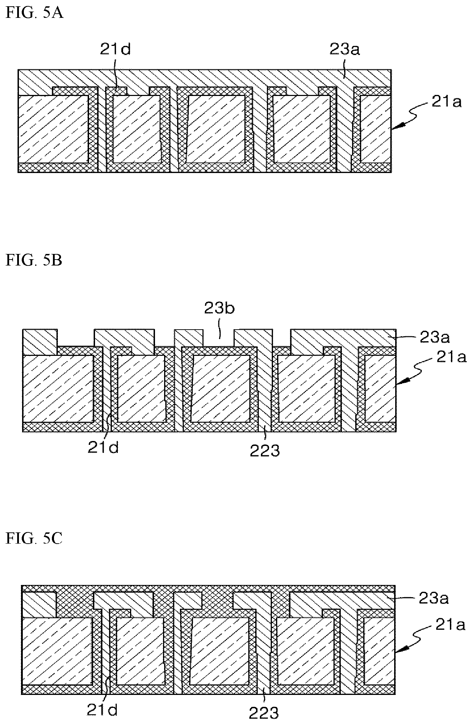

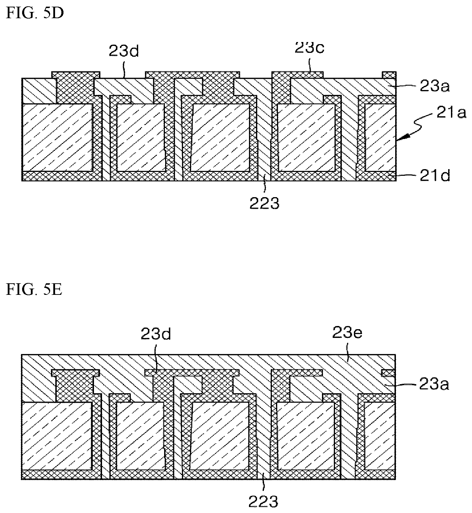

FIGS. 4A to 4E and 5A to 5E are flowcharts illustrating a cross-sectional view of the manufacturing process of a packaging substrate according to an embodiment.

First, a glass substrate 21a having a flat first and second surfaces is prepared, as shown in FIG. 4A, and a defect (groove, 21b) is formed on the glass surface at a predetermined position for forming a core via. The glass substrate may be a glass substrate applied to a substrate of an electronic device or the like, and for example, an alkali-free glass substrate or the like may be applied but is not limited thereto. As a commercially available product, a product manufactured by a manufacturer such as Corning, Schott, AGC, etc. may be applied. The formation of the defects (grooves) may be accomplished by mechanical etching, laser irradiation, or the like.

As shown in FIG. 4B, the glass substrate 21a on which the defect (groove, 21b) is formed is subjected to an etching operation to form the core vias 23 through a physical or chemical etching process. During the etching process, the glass substrate forms vias in the defects and at the same time the surface of the glass substrate 21a may also be etched. A masking film or the like may be applied to prevent such etching of the glass surface, but in consideration of the cumbersome process of applying and removing the masking film, the defective glass substrate itself may be etched, and in this case, the thickness of the glass substrate having the core vias may be somewhat thinner than the thickness of the initial glass substrate.

Then, the core layer preparation operation may be performed by forming an electrically conductive layer 21d on the glass substrate as shown in FIGS. 4C and 4D. The electrically conductive layer may be a metal layer comprising, but not limited to, copper metal.

The surface of the glass (comprising the surface of the glass substrate and the surface of the core via) and the surface of the copper metal may have different properties, which may result in poor adhesion. In an embodiment, the adhesion between the glass surface and the metal can be improved by two methods: a dry method and a wet method.

The dry method is a method of applying sputtering, that is, metal sputtering, to form a seed layer 21c on the surface of the glass and the inner diameter of the core via. In the formation of the seed layer, dissimilar metals such as titanium, chromium, nickel, and the like may be sputtered together with copper, and in this case, glass-to-metal adhesion may be improved by an anchor effect in which the surface morphology of the glass and the metal particles interact.

The wet method is a primer treatment method in which a primer layer 21c is formed by pretreatment with a compound having functional groups such as amines. Depending on the degree of adhesion desired, pretreatment with a silane coupling agent may be followed by primer treatment with a compound or particle having an amine functional group. As mentioned above, the support substrate of the embodiment needs to be of high enough performance to form a fine pattern, which should be maintained after the primer treatment. Therefore, if such primer comprises nanoparticles, it is preferred that nanoparticles having an average diameter of 150 nm or less are applied, for example, particles having amine functional groups. The primer layer can be formed by applying a bonding force improver, for example, such as the CZ series of MEC.

The seed layer/primer layer 21c may optionally form the electrically conductive layer with or without removing the portion where the formation of the electrically conductive layer is unnecessary. Furthermore, the seed layer/primer layer 21c may be optionally activated or deactivated for metal plating with or without removing the portion where the formation of the electrically conductive layer is necessary or unnecessary to proceed with the subsequent process. For example, the activation or deactivation treatment may be subjected to light irradiation treatment such as a laser of a certain wavelength, chemical treatment, or the like. The formation of the metal layer may comprise, but is not limited to, copper plating methods applied in the manufacture of semiconductor devices.

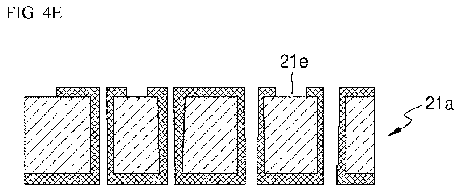

As shown in FIG. 4E, a portion of the core distribution layer may be removed if it is unnecessary, and after the seed layer is partially removed or inactivated, metal plating may be performed to form an electrically conductive layer in a predetermined pattern to form the etching layer 21e of the core distribution layer.

FIGS. 5A to 5E illustrate manufacturing operations to form an insulating layer and an upper layer pattern, according to one embodiment.

As shown in FIG. 5A, the core via may be subjected to an insulating layer formation operation in which the void space is filled with an insulating layer after the formation of the core distribution layer, which is an electrically conductive layer. In this case, the insulating layer applied may be made in the form of a film, for example, by pressure sensitive lamination of the insulating layer in the form of a film. By performing such pressure-sensitive lamination, the insulating layer can be sufficiently impregnated into the void space inside the core vias to form a core insulating layer without void formation.

FIGS. 5B to 5E illustrate the upper layer manufacturing operations.

The operation of manufacturing the upper layer is to form an upper layer comprising an upper insulating layer and an upper layering pattern on the core layer. The upper insulating layer may be formed by coating a resin composition forming the insulating layer 23a or by laminating an insulating film, and the simplest method is to laminate an insulating film. The lamination of the insulating film may be carried out by laminating the insulating film and curing it, in which case, by applying a pressure sensitive lamination method, the insulating resin may be sufficiently impregnated even to a layer in which no electrically conductive layer is formed inside the core via. The upper insulating layer is also applied in direct contact with the glass substrate, at least in part, and thus has sufficient adhesion. Specifically, the glass substrate and the upper insulating layer are preferably characterized by an adhesion test value of 4B or more according to ASTM D3359.

The upper partial pattern may be formed by repeating the process of forming the insulating layer 23a, forming the electrically conductive layer 23c in a predetermined pattern, and etching off the unnecessary parts to form the etching layer 23d of the electrically conductive layer, or, in the case of the electrically conductive layers that are formed adjacent to the insulating layer, forming a blind vias 23b on the insulating layer and then proceeding with the plating process. Dry etching methods such as laser etching, plasma etching, and the like, or wet etching methods using a masking layer and an etching solution, may be applied to form the blind vias.

Then, although not shown, a top surface contact layer and a cover layer may be formed.

The top surface connection pattern and the top surface contact electrode may also be formed by a process similar to the formation of the upper layer. Specifically, it may be formed by forming an etching layer of an insulating layer on the insulating layer 23e, forming an electrically conductive layer thereon, and then forming an etching layer of the electrically conductive layer, and so on, but it may also be applied by selectively forming only the electrically conductive layer without applying the method of etching. The cover layer may be formed such that an opening (not shown) is formed at a position corresponding to the top surface connection electrode so that the top surface connection electrode is exposed and may be directly connected to an electrical connection or a terminal of the element.

Once the upper layer has been prepared, the lower layer may be processed by forming the bottom contact layer and cover layer. The lower layer and/or the bottom surface connection layer, and optionally the cover layer (not shown), may be formed in a similar manner to the operations for forming the top contact layer and cover layer described above.

The embodiment applies a glass core as a support for the core layer. The plate glass is applied as the glass core, as opposed to conventional glass fibers impregnated with polymeric prepregs. While glass cores have many of the advantages described above, they also have the disadvantage of being subject to defects such as chipping, cracking, and chipping.

The cause of defects in glass cores is thought to be a combination of factors. Stresses or microscopic defects remaining in the glass core itself during the manufacturing process may be expressed as defects, such as cracking due to impact. In addition, during the manufacturing process of the packaging substrate, stress may be generated by the influence of dissimilar materials that are formed on both sides of the packaging substrate and/or repeated temperature changes, and these effects can lead to defects. Defects may also be caused by impact during transportation or processing. Among the defects, defects that occur roughly perpendicular to the thickness direction at the corners or edges of the glass core are called SeWaRe. SeWaRe is a progressive defect that can grow larger and deeper during the manufacturing process.

Embodiments show forming a protective layer to make it difficult for microscopic defects or small SeWaRe to develop into larger defects. In addition, during the manufacturing of the packaging substrate, a process of stress relieving the substrate may be further performed to suppress the occurrence of SeWaRe, but this may reduce the manufacturing efficiency of the packaging substrate. In an embodiment, the present invention applies a side protection layer that, when defects such as SeWaRe, cracks, and chipping are induced, fills these areas without further performing a stress relief process.

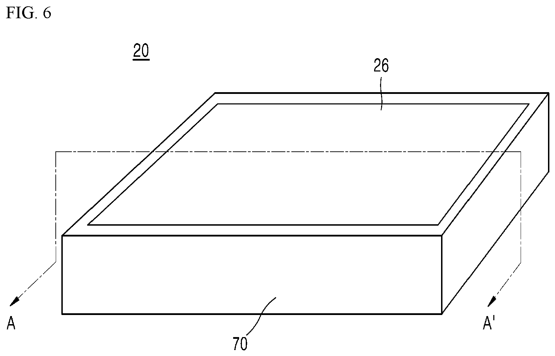

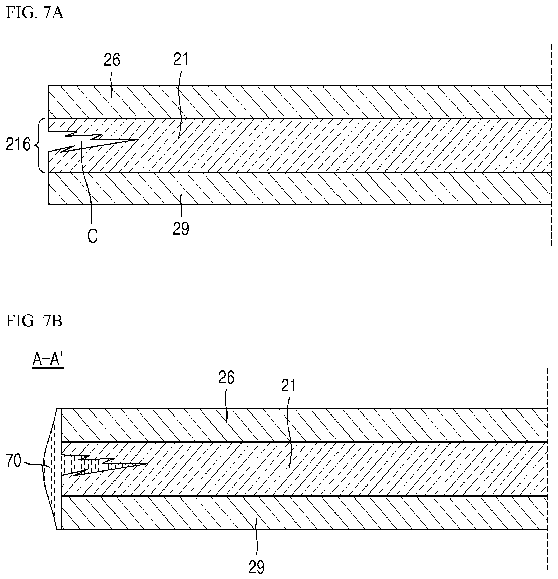

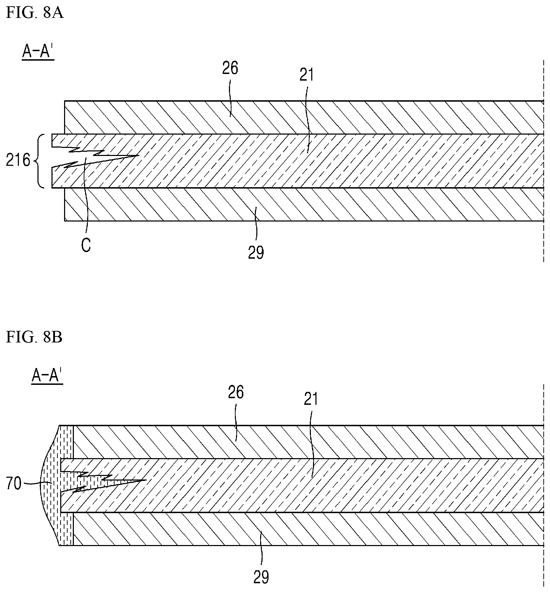

FIG. 6 is a perspective view of a substrate having a side protection layer, according to an embodiment. FIG. 7A, FIG. 8A, and FIG. 8A are exemplary conceptual views of a cross-section of the substrate before the side protection layer is formed, as seen at A-A' in FIG. 6, respectively, and FIG. 7B, FIG. 8B, and FIG. 9B are exemplary conceptual views of a cross-section of the substrate after the side protection layer is formed, as seen at A-A' in FIG. 6, respectively. Referring now to FIGS. 6 through 9B, the following embodiments will be described in detail.

The substrate comprises a packaging substrate 20 on which one or more electronic elements are disposed. The substrate comprises a glass core 21 having a first surface 213 and a second surface 214 facing each other, and a side surface 216 connecting the first surface and the second surface; an upper layer 26 laminated on the first surface or a lower layer 29 laminated under the second surface; and a side protection layer 70 covering the side surfaces of the glass core with a protective material.

The description of the glass core, the core portion, the upper layer, the lower layer, and the like applies as described above. Also, the formation of the cavity and the like are applicable to the embodiments.

A defect (C) is formed on the side surface 216 of the glass core in an inward direction of the glass core, and the protective material fills the space within the glass core caused by the defect.

The defects in the glass core are preferably not formed, but with a relatively high probability may be formed during the manufacturing of the packaging substrate. The side protective layer 70 may be formed at an operation when defects are detected. For example, the side protection layer 70 may optionally be formed one or more times on the substrate: i) prior to forming the upper layer 26 and/or lower layer 29 on the glass core, ii) during the process of forming the upper layer 26 and/or lower layer 29 on the glass core, iii) after forming the upper layer 26 and/or lower layer 29 on the glass core, and iv) after singulation into one or more individual packaging substrates.

The side protection layer 70 covers the side surface 216 of the glass core and simultaneously fills the defect C. The side protection layer comprises a protective material.

The protective material comprises an elastic material.

The elastic material may comprise an elastic polymer comprising silane functional groups.

The elastic material may be specifically a silicone elastomer.

The elastic material may have a Young's modulus at 24 °C of at least 0.1 GPa, at least 1 GPa, or at least 2 GPa. The Young's modulus may be 17 GPa or less, 15 GPa or less, 12 GPa or less, or 10 GPa or less.

The protective material may have a viscosity of 1,000 cP or more, 2,000 cP or more, or 3,000 cP or more at 25 °C in the solution state prior to curing. The viscosity may be 50,000 cP or less, 30,000 cP or less, 20,000 cP or less, or 10,000 cP or less. When applying a protective material in this viscosity range, it is helpful to increase the temperature to ensure that the protective material is incorporated into the microscopic defect, and then decrease the temperature to ensure that the material remains stably incorporated.

The elastic material may be cured at a curing temperature of 120°C or higher. The curing may be carried out by inducing a chemical reaction between the subject and the curing agent. During the curing process, the degree of chemical bonding in the elastic material can be increased, and the mechanical strength of the protective material may be imparted and controlled. The curing temperature may be 120°C or more, 125°C or more, or 130°C or more. The curing temperature may be 180°C or less, 175°C or less, or 160°C or less.

The curing temperature may be maintained for a curing time. The curing time may be at least 3 minutes, at least 5 minutes, or at least 7 minutes. The curing time may be 40 minutes or less, 35 minutes or more, or 30 minutes or less. If the curing is carried out during such a curing time, a protective material having stable mechanical properties may be obtained.

The protective material may comprise at least 70 wt% of silicone elastomers. The protective material may comprise at least 80 wt% of silicone elastomers. The protective material may comprise at least 90 wt% of silicone elastomers. The protective material may comprise less than or equal to 100% by weight of silicone elastomer.

The side protective layer 70 may be a silicone elastomer layer.

A silicone elastomer may be a cross-linked combination of a silicone resin, which is the subject material, and a curing agent.

The subject material may contain an alkene group at one or more end groups. The subject material may have the structure of Chemical Structure 1 below.

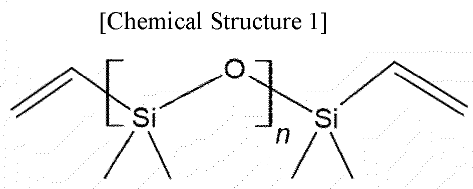

In Chemical Structure 1, n is an integer between 20 and 60.

The curing agent may have the structure of Chemical Structure 2 below.

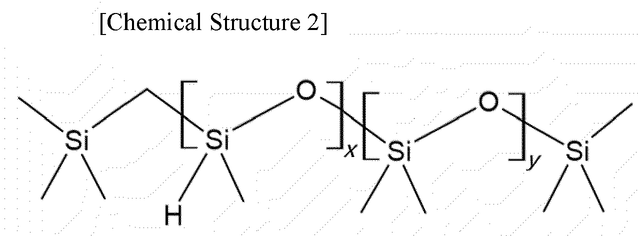

In Chemical Structure 2, x and y are integers that are each independently between 2 and 10.

During the curing process, the alkene groups contained in the subject material may form crosslinks with the curing agent. This may improve the crosslinking density in the blend resin and impart a controlled stiffness to the protective material.

When forming a protective material, at least 3 parts by weight, at least 5 parts by weight, or at least 8 parts by weight of a curing agent relative to 100 parts by weight of the subject material may be applied. When forming the protective material, the curing agent may be applied at 20 parts by weight or less, or 15 parts by weight or less, relative to 100 parts by weight of the subject material. Forming the protective material in these ranges may help to more easily fill the space created by the defect and provide the side protective layer with appropriate elasticity, strength, etc.

The formation of the side protection layer may be accomplished by applying a pre-cured composition of the protective material to the side surface of the substrate where the defect, such as cracking or chipping, has occurred, and then curing and fixing the composition. The application may be by, but is not limited to, dipping, slit coating, dry film coating, dispensing, and the like.

The tensile strength of the side protection layer 70 may be from 1 Mpa to 20 Mpa. The tensile strength may be 2 MPa or more. The tensile strength may be 4 MPa or more. The tensile strength may be 15 MPa or less. The tensile strength may be 10 MPa or less. In such a case, the substrate may have stable durability even though the glass core 21 has a structure that is vulnerable to impact. The tensile strength may be measured using a Universal Testing Machine (UTM).

The coefficient of thermal expansion of the side protection layer 70 is from 100 ppm/°C to 800 ppm/°C. The coefficient of thermal expansion may be greater than or equal to 150 ppm/ °C. The coefficient of thermal expansion may be 200 ppm/°C or more. The coefficient of thermal expansion may be greater than or equal to 250 ppm/°C. The coefficient of thermal expansion may be greater than or equal to 300 ppm/°C. The coefficient of thermal expansion may be 700 ppm/°C or less. The coefficient of thermal expansion may be 600 ppm/°C or less. The coefficient of thermal expansion may be 500 ppm/°C or less. The coefficient of thermal expansion may be 400 ppm/°C or less. In such cases, the substrate may have stable durability and electrical reliability even after repeated heat treatments. The coefficient of thermal expansion may be measured by a TMA (Thermal Mechanical Analyzer) using thermomechanical analysis. For example, the coefficient of thermal expansion may be measured with TA INSTRUMENT's Q400 model TMA.

The dielectric constant of the side protection layer 70 at a frequency of 100 Hz may be 4 or less. The dielectric constant may be 3.5 or less. The dielectric constant may be 3 or less. The dielectric constant may be 2.8 or less. The dielectric constant may be greater than or equal to 1.5.

The dielectric constant of the side protection layer 70 at a frequency of 100 kHz may be 4 or less. The dielectric constant may be 3.5 or less. The dielectric constant may be 3 or less. The dielectric constant may be 2.8 or less. The dielectric constant may be greater than or equal to 1.5.

In this case, the pattern of electrically conductive layers formed on the side protective layer 70 may perform efficient signal transmission. The dielectric constant of the side protective layer 70 is measured with a dielectric constant meter at room temperature.

If cracks, chipping, or other defects occur in the glass core, the side protective layer may be formed. Therefore, if it is confirmed that cracks, chipping, or other defects occur in the glass core itself, a side protective layer may be formed on the glass core.

If defects such as cracks, chipping, etc. occur in the glass core during the formation of the upper layer and/or the lower layer, the side protective layer is formed. The side protection layer is formed to cover some or all of the side surfaces of the upper layer and/or the lower layer.

The side protective layer covers at least a portion of the upper layer and the lower layer with the protective material.

By observing the cross-section of the substrate in the area where the defect occurs, it is possible to have a laminated structure of glass, protective material, and glass. This prevents the expansion of defects and enables the production of packaging substrate products even when glass damage such as defects occurs, thereby improving the efficiency of the manufacturing process.

In one or more embodiments, the substrate may be a strip substrate in which a plurality of individual packaging substrates is arranged with dummy areas between them.

In one or more embodiments, the substrate may be a quad substrate with a plurality of strips arranged with dummy areas between them.

In one or more embodiments, the substrate may be a quad substrate with a plurality of strips arranged with dummy areas between them.

In one or more embodiments, the substrate may be a panel substrate having a plurality of quads arranged with dummy areas between them.

For a board that is a strip board, a quad board, or a patter board, the defects, etc. generated in the dummy area at the edge of the board may be filled with a protective material and a side protective layer may be formed to prevent the board from further generating defects, breaking due to external impact, etc. The side protective layer may be removed when the substrate strip is separated into individual packaging boards.

In one or more embodiments, the substrate may be an individual packaging substrate. In this case, during the singulation process of the individual packaging substrate, defects may occur on the side surfaces of the individual packaging substrate, which may cause additional SeWaRe, etc. to occur during the process of pursuit movement, device mounting, etc. Therefore, a side protective layer may be formed on the individual packaging substrate after the cutting process, and this may improve the resilience of the individual packaging substrate to improve the impact resistance of the individual packaging substrate.

In one or more embodiments not covered by the claimed invention, the substrate may be substantially perpendicular to the first and second surfaces, comprising the side surfaces of the upper layer and/or lower layer and the side surfaces of the glass core (see FIG. 7A and FIG. 7B). Being substantially perpendicular may result in chips, cracks, and other defects at the edges, and the substrate may be protected by forming a side protection layer as shown in FIG. 7B.

According to the present invention, the substrate has side surfaces of the upper layer and/or the lower layer disposed inwardly of the side surfaces of the glass core (see FIGS. 8A and 8B). In this case, the substrate is protected by forming a side protection layer, which is formed to cover both the steps located between the upper layer and the first surface and the steps located between the lower layer and the second surface, as shown in FIG. 8B.

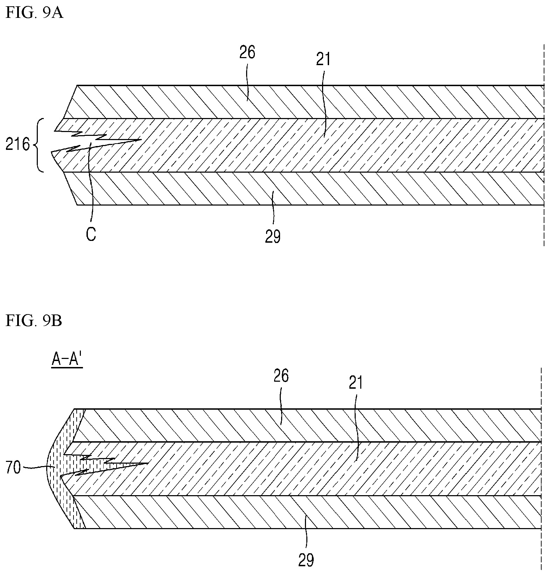

In one or more embodiments, the substrate may have side surfaces of the glass substrate having a raised center portion. Specifically, the side surfaces of the glass core may have a raised center portion and chamfered upper and lower edges, with the side surfaces of the upper layer and/or lower layer disposed inwardly of the side surfaces of the glass core (see FIGS. 9A and 9B). In this case, the side protection layer may be tapered in first and second directions around the side surfaces of the upper layer and/or lower layer and the chamfered glass substrate feature. In this case, the side protective layer may be formed to cover around the tapered side surfaces of the upper layer, the side surface of the glass substrate with a raised center portion, and the tapered side surfaces of the lower layer to protect the substrate, as shown in FIG. 9B.

A manufacturing method of a substrate having a side protection layer, according to another embodiment, comprises: operation A of preparing a substrate by preparing a glass core comprising a first surface and a second surface facing each other, and forming an upper layer on the first surface and a lower layer under the second surface; and operation B of preparing a side protection layer on a side surface of the substrate.

The glass core of the substrate is a glass core having a defect formed on a side surface thereof, and the side protective layer is a protective layer filling the defect with a protective material and covering the side surface of the glass core, and the specific structure, form, physical properties, etc. are the same as those described above, so detailed descriptions are omitted.

The methods for preparing the upper and/or lower layers are redundant to those described above and will not be described in detail.

The method of forming the side protective layer may comprise preparing a pre-curing protective material (composition) in the form of a liquid or dry film, applying it, and then curing it. The thickness of the side protective layer is sufficient to cover the side surface of the glass core, and the side protective layer filling the space of the defect and covering the side surface of the glass core at the same time may substantially inhibit the spread of damage to the glass core and protect the glass core from further impact.

The manufacturing method of the substrate may proceed to operation C in the progress of the operation A or at least once between the operation A and the operation B.

The Operation C is to check the occurrence of defects on the substrate in the operation A.

The operation C may be performed repeatedly during the formation of the glass core, upper layer, and/or lower layer in which defect generation is provided. For example, it may be performed repeatedly after one or more insulating layers comprising the polymer have been formed.

The manufacturing method of the substrate may further comprise operation D after the operation A.

The substrate of operation A is a substrate in which a plurality of individual packaging substrates is arranged within a dummy region, and operation D is a singulation operation in which the individual packaging substrates are separated to obtain a packaging substrate.

The singulation method may be the method of separation.

The singulation method may comprise, for example, removing the upper layer and/or lower layer along a cut line, forming a groove in a portion of the glass core, and impacting the substrate to obtain an individual packaging substrate with the dummy region removed along the cut line.

The cut surface from which the dummy area has been removed may be substantially straight and may have a cross-section in the form of FIG. 8A. Further, the glass core of the cross-section of FIG. 8B may be chamfered or ground at the edges by a subsequent grinding operation or the like and may have a cross-section in the form of FIG. 9A. The side surfaces of the singulated individual packaging substrate also form a side protective layer by checking whether defects in the cross-section occur.

The substrate of the embodiments can reduce packaging substrate failures due to defects such as SeWaRe that are prone to occur (or manifest) in the glass core and improve durability. In addition, the manufacturing yield of the substrate can be improved by compensating for defects that occur even if a process to de-stress the glass core is not performed separately. Furthermore, additional defects such as cracking and chipping at the edges and/or corners of the substrate, which can occur when the substrate is placed in a tray or boat for processing, can be minimized.

## Claims

1. A substrate, comprising a packaging substrate (20) on which one or more electronic elements (32, 34, 36) are disposed,
wherein the packaging substrate comprises:
a glass core (21) comprising a first surface (213) and a second surface (214) facing each other, and a side surface (216) connecting the first surface (213) and the second surface (214);
an upper layer (26) stacked on top of the first surface (213), and a lower layer (29) stacked below the second surface (214), wherein the side surface (216) of the glass core (21) protrudes from a side surface of the upper layer (26) and a side surface of the lower layer (29); and
a side protective layer (70) covering the side surfaces (216) of the glass core (21), the side surfaces of the upper layer (26) and the lower layer (29), and both a step located between the upper layer (26) and the first surface (213) and a step located between the lower layer (29) and the second surface (214) with a protective material,
wherein the protective material comprises an elastic polymeric resin;
wherein a defect (C) is formed on the side surface (216) of the glass core (21) in an inward direction of the glass core (21), and the protective material fills a space within the glass core (21) caused by the defect (C).

2. The substrate of claim 1, wherein the protective material has a Young's modulus of 0.1 GPa to 17 GPa at 24 °C.

3. The substrate of claim 1, wherein the elastic polymeric resin has a curing temperature of 120°C or more.

4. The substrate of claim 1, further comprising:
a strip substrate in which a plurality of individual packaging substrates (20) is arranged with dummy regions between them;
a quad substrate with dummy regions placed between a plurality of the strips;
a panel substrate with dummy regions disposed between the plurality of the quad substrate; or
an individual packaging substrate (20).

5. The substrate of claim 1, wherein the side surface (216) of the glass core (21) has a raised center portion and chamfered upper and lower edges with the side surfaces of the upper layer (26) and lower layer (29) disposed inwardly of the side surface (216) of the glass core (21), and wherein the side protection layer (70) is formed to cover around the tapered side surfaces of the upper layer (26), the side surface (216) of the glass core (21) with a raised center portion, and the tapered side surfaces of the lower layer (29) to protect the substrate.

6. The substrate of claim 1, wherein the elastic polymeric resin comprises silane functional groups.

7. A method of manufacturing a substrate having a side protective layer (70), comprising:
operation A of preparing the substrate by preparing a glass core (21) comprising a first surface (213) and a second surface (214) facing each other, and forming an upper layer (26) on the first surface (213) and a lower layer (29) under the second surface (214), wherein the side surface (216) of the glass core (21) protrudes from a side surface of the upper layer (26) and a side surface of the lower layer (29), and wherein the protective material comprises an elastic polymeric resin; and
operation B of preparing a side protective layer (70) on the side surfaces (216) of the glass core (21), the side surfaces of the upper layer (26) and the lower layer (29), and both on a step located between the upper layer (26) and the first surface (213) and a step located between the lower layer (29) and the second surface (214),
wherein the glass core (21) of the substrate has defects (C) formed on the side surfaces (216), and
at the side protective layer (70), a protective material fills the defects (C) and covers the side surface (216) of the glass core (21).

8. The manufacturing method of the substrate of claim 7
wherein operation C is performed one or more times during the operation A or between the operation A and the operation B, and
the operation C is an operation of identifying an occurrence of defects (C) on the substrate of the operation A.

9. The manufacturing method of the substrate of claim 7,
wherein operation D is further performed after the operation A,
wherein the substrate of operation A has a plurality of individual packaging substrates (20) arranged in a dummy region, and
the operation D is a singulation operation of separating the individual packaging substrate (20).

## Patentansprüche

1. Substrat, umfassend ein Gehäusesubstrat (20), auf dem ein oder mehrere elektronische Elemente (32, 34, 36) angeordnet sind,
wobei das Gehäusesubstrat umfasst:
einen Glaskern (21), der eine erste Oberfläche (213) und eine zweite Oberfläche (214), die einander gegenüberliegen, sowie eine Seitenfläche (216), die die erste Oberfläche (213) und die zweite Oberfläche (214) verbindet, umfasst;
eine obere Schicht (26), die oben auf der ersten Oberfläche (213) gestapelt ist, und eine untere Schicht (29), die unterhalb der zweiten Oberfläche (214) gestapelt ist, wobei die Seitenfläche (216) des Glaskerns (21) über eine Seitenfläche der oberen Schicht (26) und eine Seitenfläche der unteren Schicht (29) hinausragt; und
eine Seitenschutzschicht (70), die die Seitenflächen (216) des Glaskerns (21), die Seitenflächen der oberen Schicht (26) und der unteren Schicht (29) sowie sowohl eine zwischen der oberen Schicht (26) und der ersten Oberfläche (213) gelegene Stufe als auch eine zwischen der unteren Schicht (29) und der zweiten Oberfläche (214) gelegene Stufe mit einem Schutzmaterial bedeckt,
wobei das Schutzmaterial ein elastisches Polymerharz umfasst;
wobei ein Defekt (C) an der Seitenfläche (216) des Glaskerns (21) in Richtung des Inneren des Glaskerns (21) ausgebildet ist und das Schutzmaterial einen durch den Defekt (C) verursachten Raum innerhalb des Glaskerns (21) ausfüllt.

2. Substrat nach Anspruch 1, wobei das Schutzmaterial einen Elastizitätsmodul von 0,1 GPa bis 17 GPa bei 24 °C aufweist.

3. Substrat nach Anspruch 1, wobei das elastische Polymerharz eine Aushärtungstemperatur von 120 °C oder mehr aufweist.

4. Substrat nach Anspruch 1, ferner umfassend:
ein Streifensubstrat, in dem eine Mehrzahl einzelner Gehäusesubstrate (20) mit Dummy-Bereichen zwischen ihnen angeordnet ist;
ein Quad-Substrat mit Dummy-Bereichen, die zwischen einer Mehrzahl der Streifen platziert sind;
ein Panel-Substrat mit Dummy-Bereichen, die zwischen der Mehrzahl der Quad-Substrate angeordnet sind; oder
ein einzelnes Gehäusesubstrat (20).

5. Substrat nach Anspruch 1, wobei die Seitenfläche (216) des Glaskerns (21) einen erhabenen Mittelabschnitt und angefaste obere und untere Kanten aufweist, wobei die Seitenflächen der oberen Schicht (26) und der unteren Schicht (29) gegenüber der Seitenfläche (216) des Glaskerns (21) nach innen versetzt angeordnet sind, und wobei die Seitenschutzschicht (70) so ausgebildet ist, dass sie die sich verjüngenden Seitenflächen der oberen Schicht (26), die Seitenfläche (216) des Glaskerns (21) mit einem erhabenen Mittelabschnitt und die sich verjüngenden Seitenflächen der unteren Schicht (29) ringsum bedeckt, um das Substrat zu schützen.

6. Substrat nach Anspruch 1, wobei das elastische Polymerharz funktionelle Silangruppen umfasst.

7. Verfahren zur Herstellung eines Substrats, das eine Seitenschutzschicht (70) aufweist, umfassend:
einen Vorgang A des Bereitstellens des Substrats durch Bereitstellen eines Glaskerns (21), der eine erste Oberfläche (213) und eine zweite Oberfläche (214), die einander gegenüberliegen, umfasst, und durch Ausbilden einer oberen Schicht (26) auf der ersten Oberfläche (213) und einer unteren Schicht (29) unter der zweiten Oberfläche (214), wobei die Seitenfläche (216) des Glaskerns (21) über eine Seitenfläche der oberen Schicht (26) und eine Seitenfläche der unteren Schicht (29) hinausragt und wobei das Schutzmaterial ein elastisches Polymerharz umfasst; und
einen Vorgang B des Bereitstellens einer Seitenschutzschicht (70) auf den Seitenflächen (216) des Glaskerns (21), den Seitenflächen der oberen Schicht (26) und der unteren Schicht (29) sowie sowohl auf einer zwischen der oberen Schicht (26) und der ersten Oberfläche (213) gelegenen Stufe als auch auf einer zwischen der unteren Schicht (29) und der zweiten Oberfläche (214) gelegenen Stufe,
wobei der Glaskern (21) des Substrats Defekte (C) aufweist, die an den Seitenflächen (216) ausgebildet sind, und
an der Seitenschutzschicht (70) ein Schutzmaterial die Defekte (C) ausfüllt und die Seitenfläche (216) des Glaskerns (21) bedeckt.

8. Herstellungsverfahren des Substrats nach Anspruch 7,
wobei Vorgang C einmal oder mehrmals während des Vorgangs A oder zwischen dem Vorgang A und dem Vorgang B durchgeführt wird und
der Vorgang C ein Vorgang des Feststellens eines Auftretens von Defekten (C) an dem Substrat des Vorgangs A ist.

9. Herstellungsverfahren des Substrats nach Anspruch 7,
wobei Vorgang D ferner nach dem Vorgang A durchgeführt wird,
wobei das Substrat des Vorgangs A eine Mehrzahl einzelner Gehäusesubstrate (20) aufweist, die in einem Dummy-Bereich angeordnet sind, und
der Vorgang D ein Vereinzelungsvorgang zum Trennen des einzelnen Gehäusesubstrats (20) ist.

## Revendications

1. Substrat, comprenant un substrat de boîtier (20) sur lequel un ou plusieurs éléments électroniques (32, 34, 36) sont disposés,
dans lequel le substrat de boîtier comprend :
un noyau de verre (21) comprenant une première surface (213) et une seconde surface (214) se faisant face, et une surface latérale (216) reliant la première surface (213) et la seconde surface (214) ;
une couche supérieure (26) empilée sur la première surface (213), et une couche inférieure (29) empilée sous la seconde surface (214), dans lequel la surface latérale (216) du noyau de verre (21) fait saillie par rapport à une surface latérale de la couche supérieure (26) et à une surface latérale de la couche inférieure (29) ; et
une couche de protection latérale (70) recouvrant les surfaces latérales (216) du noyau de verre (21), les surfaces latérales de la couche supérieure (26) et de la couche inférieure (29), et à la fois un décrochement situé entre la couche supérieure (26) et la première surface (213) et un décrochement situé entre la couche inférieure (29) et la seconde surface (214) avec un matériau de protection,
dans lequel le matériau de protection comprend une résine polymère élastique;
dans lequel un défaut (C) est formé sur la surface latérale (216) du noyau de verre (21) dans une direction vers l'intérieur du noyau de verre (21), et le matériau de protection remplit un espace à l'intérieur du noyau de verre (21) causé par le défaut (C).

2. Substrat selon la revendication 1, dans lequel le matériau de protection présente un module de Young de 0,1 GPa à 17 GPa à 24 °C.

3. Substrat selon la revendication 1, dans lequel la résine polymère élastique présente une température de durcissement de 120 °C ou plus.

4. Substrat selon la revendication 1, comprenant en outre :
un substrat en bande dans lequel une pluralité de substrats de boîtier individuels (20) est disposée avec des zones factices entre eux ;
un substrat quad avec des zones factices placées entre une pluralité des bandes ;
un substrat de panneau avec des zones factices disposées entre la pluralité des substrats quad ; ou
un substrat de boîtier individuel (20).

5. Substrat selon la revendication 1, dans lequel la surface latérale (216) du noyau de verre (21) présente une partie centrale surélevée et des arêtes supérieures et inférieures chanfreinées, avec les surfaces latérales de la couche supérieure (26) et de la couche inférieure (29) disposées vers l'intérieur par rapport à la surface latérale (216) du noyau de verre (21), et dans lequel la couche de protection latérale (70) est formée pour recouvrir tout autour les surfaces latérales effilées de la couche supérieure (26), la surface latérale (216) du noyau de verre (21) avec une partie centrale surélevée, et les surfaces latérales effilées de la couche inférieure (29) afin de protéger le substrat.

6. Substrat selon la revendication 1, dans lequel la résine polymère élastique comprend des groupes fonctionnels silane.

7. Procédé de fabrication d'un substrat ayant une couche de protection latérale (70), comprenant :
une opération A de préparation du substrat par préparation d'un noyau de verre (21) comprenant une première surface (213) et une seconde surface (214) se faisant face, et par formation d'une couche supérieure (26) sur la première surface (213) et d'une couche inférieure (29) sous la seconde surface (214), dans lequel la surface latérale (216) du noyau de verre (21) fait saillie par rapport à une surface latérale de la couche supérieure (26) et à une surface latérale de la couche inférieure (29), et dans lequel le matériau de protection comprend une résine polymère élastique ; et
une opération B de préparation d'une couche de protection latérale (70) sur les surfaces latérales (216) du noyau de verre (21), les surfaces latérales de la couche supérieure (26) et de la couche inférieure (29), et à la fois sur un décrochement situé entre la couche supérieure (26) et la première surface (213) et sur un décrochement situé entre la couche inférieure (29) et la seconde surface (214),
dans lequel le noyau de verre (21) du substrat présente des défauts (C) formés sur les surfaces latérales (216), et
au niveau de la couche de protection latérale (70), un matériau de protection remplit les défauts (C) et recouvre la surface latérale (216) du noyau de verre (21).

8. Procédé de fabrication du substrat selon la revendication 7,
dans lequel l'opération C est effectuée une ou plusieurs fois pendant l'opération A ou entre l'opération A et l'opération B, et
l'opération C est une opération d'identification d'une occurrence de défauts (C) sur le substrat de l'opération A.

9. Procédé de fabrication du substrat selon la revendication 7,
dans lequel l'opération D est en outre effectuée après l'opération A,
dans lequel le substrat de l'opération A présente une pluralité de substrats de boîtier individuels (20) disposés dans une zone factice, et
l'opération D est une opération d'individualisation consistant à séparer le substrat de boîtier individuel (20).
